# DEMANDE DE BREVET EUROPEEN

(11) **EP 3 812 347 A1**
(43) Date de publication de la demande: **28.04.2021**
(21) Numéro de dépôt: 20201237.3
(22) Date de dépôt: 12.10.2020
(51) Int. Cl.: B81C 1/00, G03F 7/00, H01L 21/027

(54) **PROCÉDÉ DE FORMATION D'UNE STRUCTURE DE GUIDAGE CHIMIQUE SUR UN SUBSTRAT ET PROCÉDÉ DE CHÉMO-ÉPITAXIE**

(30) Priorité: 16.10.2019 FR 1911542
(71) Demandeur: Commissariat à l'Energie Atomique et aux Energies Alternatives, 75015 Paris (FR)
(72) Inventeur: TIRON, Raluca, 38054 GRENOBLE CEDEX 09 (FR); GIAMMARIA, Tommaso-Jacopo, 38054 GRENOBLE CEDEX 09 (FR)
(74) Mandataire: Cabinet Camus Lebkiri

(57) **Abrégé**

Un aspect de l'invention concerne un procédé de formation d'une structure de guidage chimique destinée à l'auto-assemblage de nano-objets organiques par chémo-épitaxie, le procédé comprenant les étapes suivantes :
- former sur un substrat (100) des motifs sacrificiels (300) ayant une dimension critique (CDs) dans un plan parallèle au substrat (100) ;
- former sur le substrat (100), entre les motifs sacrificiels (300), au moins un premier motif (210a) en un premier matériau polymère, le premier matériau polymère ayant une première affinité chimique (AF1) par rapport aux nano-objets organiques ;
- graver (S13) partiellement les motifs sacrificiels (300) de façon à réduire la dimension critique (CDs) des motifs sacrificiels, les motifs sacrificiels (300) étant gravés sélectivement par rapport audit au moins un premier motif (210a) en utilisant un premier procédé de gravure humide ;
- former sur le substrat (100), dans des zones (100b) créées par la gravure partielle des motifs sacrificiels (300), des deuxièmes motifs en un deuxième matériau polymère, le deuxième matériau polymère ayant une deuxième affinité chimique par rapport aux nano-objets organiques, différente de la première affinité chimique (AF1) ; et
- retirer les motifs sacrificiels (300).

## Description

### DOMAINE TECHNIQUE DE L'INVENTION

La présente invention concerne un procédé de formation d'une structure de guidage chimique destinée à l'auto-assemblage dirigé de nano-objets organiques par chémo-épitaxie. La présente invention concerne également un procédé de chémo-épitaxie à partir d'une structure de guidage chimique.

### ARRIERE-PLAN TECHNOLOGIQUE DE L'INVENTION

L'auto-assemblage dirigé de copolymères à blocs (DSA, pour « Directed Self-Assembly » en anglais) est une technique de lithographie émergente permettant de former des motifs de dimension critique inférieure à 30 nm. Cette technique constitue une alternative moins onéreuse à la lithographie extrême ultraviolet (EUV) et à la lithographie par faisceau d'électrons (« e-beam »).

Les procédés connus d'auto-assemblage de copolymères à blocs peuvent être regroupés en deux catégories : la grapho-épitaxie et la chémo-épitaxie.

La grapho-épitaxie consiste à former des motifs topographiques primaires appelés guides à la surface d'un substrat, ces motifs délimitant des zones à l'intérieur desquelles une couche de copolymère à blocs est déposée. Les motifs de guidage permettent de contrôler l'organisation des blocs de copolymère pour former des motifs secondaires de plus haute résolution à l'intérieur de ces zones.

La chémo-épitaxie consiste à modifier les propriétés chimiques de certaines régions de la surface du substrat, pour guider l'organisation du copolymère à blocs déposé ultérieurement sur cette surface. La modification chimique du substrat peut notamment être obtenue par le greffage d'une couche de neutralisation en polymère. Puis, cette couche de neutralisation est structurée afin de créer un contraste chimique à la surface du substrat. Ainsi, les régions du substrat non recouvertes par la couche de neutralisation ont une affinité chimique préférentielle pour l'un des blocs du copolymère, tandis que les régions du substrat recouvertes par la couche de neutralisation ont une affinité chimique équivalente pour tous les blocs du copolymère. La structuration de la couche de neutralisation est classiquement obtenue par une étape de lithographie optique ou à faisceau d'électrons.

La chémo-épitaxie peut également être utilisée pour d'autres types de nano-objets organiques et notamment des systèmes bio-inspirés, tels que des protéines, des brins d'ADN ou des origamis d'ADN. Les exemples de procédé décrits par la suite sont appliqués aux copolymères à blocs mais s'appliqueraient de manière analogue pour l'auto-assemblage de protéines, de brins d'ADN ou encore d'origamis d'ADN.

Pour garantir un assemblage du copolymère à blocs avec un minimum de défauts d'organisation, les régions du substrat ayant une affinité préférentielle pour l'un des blocs sont typiquement de largeur W égale à la largeur du domaine de ce bloc, cette dernière étant égale à la moitié de la période naturelle L₀ du copolymère (W = 0,5^{∗}L₀) ou égale à une fois et demie cette période naturelle (W = 1,5^{∗}L₀). En outre, les régions du substrat ayant une affinité préférentielle sont typiquement séparées deux à deux d'une distance L_{S} égale à un multiple entier de la période Lo (L_{S} = n^{∗}L₀, avec *n* un entier naturel non nul appelé facteur de multiplication du pas).

L'article de C-C. Liu et al. intitulé [« Integration of block copolymer directed assembly with 193 immersion lithography », J. Vac. Sci. Technol., B 28, C6B30-C6B34, 2010] décrit un procédé de chémo-épitaxie comprenant la formation d'une structure de guidage chimique à la surface d'un substrat. La structure de guidage chimique est composée de motifs de guidage en un polymère ayant une affinité préférentielle pour l'un des blocs du copolymère et d'un film de copolymère statistique greffé sur le substrat en dehors des motifs, dans une région dite d'arrière-plan. Le copolymère statistique est neutre par rapport au copolymère à blocs, de sorte que les domaines du copolymère soient (après assemblage) orientés perpendiculairement au substrat. La structure de guidage chimique est destinée à diriger l'auto-assemblage du copolymère à blocs PS-*b*-PMMA (polystyrène-*bloc*-polyméthylméthacrylate). Les motifs de guidage, en forme de lignes, sont constitués de polystyrène réticulé (X-PS). Le copolymère statistique, greffé entre les lignes, est le PS-r-PMMA.

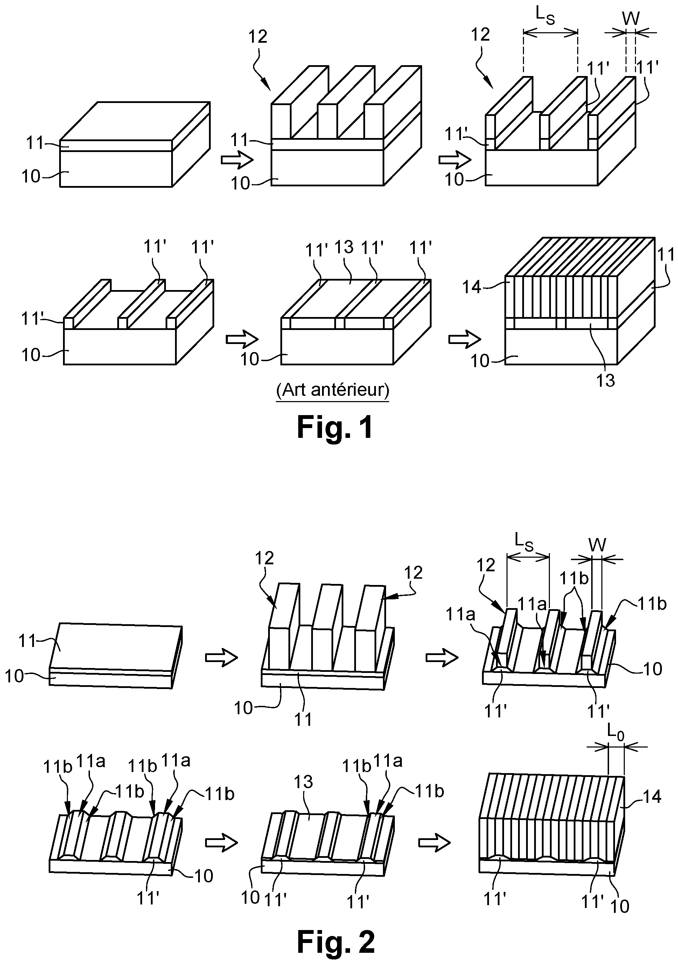

En référence à la figure 1, ce procédé de chémo-épitaxie comprend tout d'abord la formation d'un film de polystyrène réticulé 11 sur un substrat en silicium 10. Un masque constitué de motifs en résine 12 est ensuite formé sur le film de polystyrène réticulé 11, par lithographie optique (typiquement en 193 nm immersion). Puis, les motifs de résine 12 sont gravés au moyen d'un plasma à base d'oxygène jusqu'à atteindre une largeur W d'environ la moitié de la période naturelle L₀ du copolymère à blocs. Lors de cette étape, le film de polystyrène réticulé 11 est également gravé à travers le masque 12 par le plasma. Cette étape de gravure est communément appelée « trim etch ». Des motifs de polystyrène réticulé, en forme de lignes 11' parallèles, sont ainsi formés sur le substrat 10. Après l'étape de gravure « trim etch », les lignes de polystyrène 11' ont une largeur W égale à 15 nm et sont espacées deux à deux d'une distance Ls égale à 90 nm. Après retrait du masque 12 en résine, le substrat 10 est recouvert d'une solution comprenant le copolymère statistique greffable, puis le copolymère statistique est greffé entre les lignes 11' pour former une couche de neutralisation 13. Enfin, une couche de PS-*b*-PMMA 14 est déposée puis assemblée sur la structure de guidage chimique composée des lignes de polystyrène 11' et de la couche de neutralisation 13.

Le document [« Three-Tone Chemical Patterns for Block Copolymer Directed Self-Assembly », L. D. Williamson et al., ACS Appl. Mater. Interfaces, 8, pp.2704-2712, 2016] décrit une variante du procédé de chémo-épitaxie selon la figure 1.

Dans cette variante de procédé, illustrée par la figure 2, l'étape de gravure « trim etch » est accomplie de façon à ne graver que partiellement le film de polystyrène réticulé 11 en dehors des motifs de résine 12 et à obtenir des lignes de polystyrène 11' de section trapézoïdale. Chaque ligne de polystyrène 11' comprend alors une face supérieure 11a recouverte par un motif de résine 12, et de part et d'autre de la face supérieure 11a, deux flancs obliques 11b qui ont été exposés au plasma d'oxygène. L'exposition au plasma ayant pour effet d'oxyder le polystyrène, les flancs obliques 11b des lignes de polystyrène 11' présentent une affinité préférentielle pour le bloc PMMA, tandis que la face supérieure 11a des lignes de polystyrène 11' (protégée par le motif de résine 12 lors de la gravure plasma) conserve une affinité préférentielle pour le bloc PS.

La structure de guidage chimique, obtenue après retrait des motifs en résine 12 et formation d'une couche de neutralisation 13, comprend ainsi :
- des premiers motifs de guidage en polystyrène non modifié, correspondant à la face supérieure 11a des lignes de polystyrène 11' et présentant une affinité préférentielle pour le bloc PS ;
- des seconds motifs de guidage en polystyrène modifié (i.e. oxydé), correspondant aux flancs obliques 11b des lignes de polystyrène 11' et présentant une affinité préférentielle pour le bloc PMMA, chacun des premiers motifs de guidage 11a étant bordé par deux seconds motifs de guidage 11b ; et
- la couche de neutralisation 13 disposée dans la région d'arrière-plan, entre les différents groupes de motifs de guidage.

Cette structure de guidage chimique est appelée « à tonalité triple» (« three-tone » en anglais), car elle présente trois affinités chimiques différentes pour l'assemblage du copolymère à blocs 14 : affine envers le PS, affine envers le PMMA et neutre. En raison du nombre plus important de motifs de guidage dans la structure de guidage à tonalité triple, la cinétique d'assemblage du copolymère à blocs est augmentée et le nombre de défauts d'organisation est réduit.

Dans le procédé de chémo-épitaxie de la figure 1, et plus encore dans celui de la figure 2, il est difficile de contrôler précisément la largeur ou dimension critique W des motifs de guidage en forme de bande. L'étape de gravure « trim etch » par un plasma d'oxygène est en effet délicate à mettre en œuvre, en particulier avec des motifs de résine aussi étroits. En outre, dans le procédé de la figure 2, l'affinité des seconds motifs de guidage 11b est dictée par le traitement au plasma d'oxygène. Il n'est donc pas possible de choisir librement l'affinité chimique de ces motifs de guidage.

### RESUME DE L'INVENTION

Il existe un besoin de prévoir un procédé de formation d'une structure de guidage chimique, permettant un meilleur contrôle dimensionnel des motifs de guidage et un libre choix des affinités chimiques par rapport aux nano-objets organiques à assembler, tels que les domaines d'un copolymère à blocs.

Selon un premier aspect de l'invention, on tend à satisfaire ce besoin en prévoyant un procédé de formation d'une structure de guidage chimique destinée à l'auto-assemblage de nano-objets organiques par chémo-épitaxie, ce procédé comprenant les étapes suivantes :
- former sur un substrat des motifs sacrificiels ayant une dimension critique dans un plan parallèle au substrat ;
- former sur le substrat, entre les motifs sacrificiels, au moins un premier motif en un premier matériau polymère, le premier matériau polymère ayant une première affinité chimique par rapport aux nano-objets organiques ;
- graver partiellement les motifs sacrificiels de façon à réduire la dimension critique des motifs sacrificiels, les motifs sacrificiels étant gravés sélectivement par rapport audit au moins un premier motif en utilisant un premier procédé de gravure humide ;
- former sur le substrat, dans des zones créées par la gravure partielle des motifs sacrificiels, des deuxièmes motifs en un deuxième matériau polymère, le deuxième matériau polymère ayant une deuxième affinité chimique par rapport aux nano-objets organiques, différente de la première affinité chimique ; et
- retirer les motifs sacrificiels.

Dans les procédés de l'art antérieur, la gravure des motifs de résine appelée « trim etch » est employée pour délimiter des motifs de guidage dans une couche de polymère (X-PS) déposée préalablement. A l'inverse, dans le procédé selon le premier aspect de l'invention, la gravure sélective des motifs sacrificiels sert à créer (i.e. libérer) des zones dans lesquelles un matériau polymère est ultérieurement déposé pour former de nouveaux motifs de guidage. Autrement dit, seuls les motifs sacrificiels sont gravés dans le procédé selon le premier aspect de l'invention. Le matériau polymère peut être choisi librement en fonction de l'affinité souhaitée pour les nouveaux motifs de guidage.

Un procédé de gravure humide est employé pour graver les motifs sacrificiels sélectivement par rapport au(x) motif(s) de guidage existant(s). Celui-ci procure un meilleur contrôle dimensionnel que le procédé de gravure sèche (par plasma) employé dans l'art antérieur.

Dans un premier mode de mise en œuvre, le procédé comprend en outre une étape de formation sur le substrat, dans des zones créées par le retrait des motifs sacrificiels, de troisièmes motifs en un troisième matériau polymère.

Selon un développement de ce premier mode de mise en œuvre, le troisième matériau polymère présente une troisième affinité chimique par rapport aux nano-objets organiques, différente de la deuxième affinité chimique.

Selon un autre développement, le troisième matériau polymère présente la première affinité chimique.

Dans un deuxième mode de mise en œuvre, le procédé comprend en outre, entre l'étape de formation des deuxièmes motifs et l'étape de retrait des motifs sacrificiels, les étapes suivantes :
- graver partiellement les motifs sacrificiels de façon à réduire la dimension critique des motifs sacrificiels, les motifs sacrificiels étant gravés sélectivement par rapport audit au moins un premier motif et aux deuxièmes motifs en utilisant un deuxième procédé de gravure humide ;
- former sur le substrat, dans des zones créées par la gravure partielle des motifs sacrificiels, des quatrièmes motifs en un quatrième matériau polymère.

Selon un développement de ce deuxième mode de mise en œuvre, le quatrième matériau polymère présente une quatrième affinité chimique par rapport aux nano-objets organiques, différente de la deuxième affinité chimique.

Selon un autre développement, le quatrième matériau polymère présente la première affinité chimique.

Selon un autre développement, le troisième matériau polymère présente la deuxième affinité chimique.

Dans un troisième mode de mise en œuvre, le procédé comprend en outre, entre l'étape de formation des quatrièmes motifs et l'étape de retrait des motifs sacrificiels, les étapes suivantes :
- graver partiellement les motifs sacrificiels de façon à réduire la dimension critique des motifs sacrificiels, les motifs sacrificiels étant gravés sélectivement par rapport audit au moins un premier motif, aux deuxièmes motifs et aux quatrièmes motifs en utilisant un troisième procédé de gravure humide ;
- former sur le substrat, dans des zones créées par la gravure partielle des motifs sacrificiels, des cinquièmes motifs en un cinquième matériau polymère.

Selon un développement de ce troisième mode de mise en œuvre, le quatrième matériau polymère présente une quatrième affinité chimique par rapport aux nano-objets organiques, différente de la deuxième affinité chimique, et le cinquième matériau polymère présente la deuxième affinité chimique.

Selon un autre développement, le troisième matériau polymère présente la première affinité chimique.

Outre les caractéristiques qui viennent d'être évoquées dans les paragraphes précédents, le procédé de formation de structure de guidage chimique selon le premier aspect de l'invention peut présenter une ou plusieurs caractéristiques complémentaires parmi les suivantes, considérées individuellement ou selon toutes les combinaisons techniquement possibles :
- le premier procédé de gravure humide, le deuxième procédé de gravure humide et/ou le troisième procédé de gravure humide sont accomplis au moyen d'une même solution chimique ;
- les motifs sacrificiels sont constitués d'un oxyde de silicium ; et
- la solution chimique est une solution d'acide fluorhydrique.

Un deuxième aspect de l'invention concerne un procédé de chémo-épitaxie comprenant la formation d'une structure de guidage chimique sur un substrat à l'aide du procédé de formation décrit ci-dessus, le dépôt de nano-objets organiques sur la structure de guidage chimique et l'assemblage des nano-objets organiques.

Les nano-objets organiques peuvent être choisis parmi des domaines d'un copolymère à blocs, des brins d'ADN, des origamis d'ADN et des protéines.

L'invention et ses différentes applications seront mieux comprises à la lecture de la description qui suit et à l'examen des figures qui l'accompagnent.

### BREVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :
[Fig. 1], précédemment décrite, représente des étapes d'un procédé de chémo-épitaxie selon l'art antérieur ;
[Fig. 2], précédemment décrite, représente une variante du procédé de chémo-épitaxie selon la figure 1 ;
[Fig. 3A], [Fig. 3B], [Fig. 3C], [Fig. 3D], [Fig. 3E] et [Fig. 3F] représentent des étapes d'un procédé pour former une structure de guidage chimique, selon un premier mode de mise en œuvre de l'invention ;
[Fig. 4] représente schématiquement l'assemblage d'un copolymère à blocs déposé sur la structure de guidage chimique de la figure 3F ;
[Fig. 5A], [Fig. 5B], [Fig. 5C], [Fig. 5D], [Fig. 5E], [Fig. 5F], [Fig. 5G] et [Fig. 5H] représentent des étapes d'un procédé pour former une structure de guidage chimique, selon un deuxième mode de mise en œuvre de l'invention ;
[Fig. 6E], [Fig. 6F], [Fig. 6G], [Fig. 6H], [Fig. 6I] et [Fig. 6J] représentent, en compléments des étapes des figures 5A à 5D, des étapes d'un procédé pour former une structure de guidage chimique, selon un troisième mode de mise en œuvre de l'invention ; et
[Fig. 7] représente schématiquement l'assemblage d'un copolymère à blocs déposé sur la structure de guidage chimique de la figure 6J.

Pour plus de clarté, les éléments identiques ou similaires sont repérés par des signes de référence identiques sur l'ensemble des figures.

### DESCRIPTION DETAILLEE

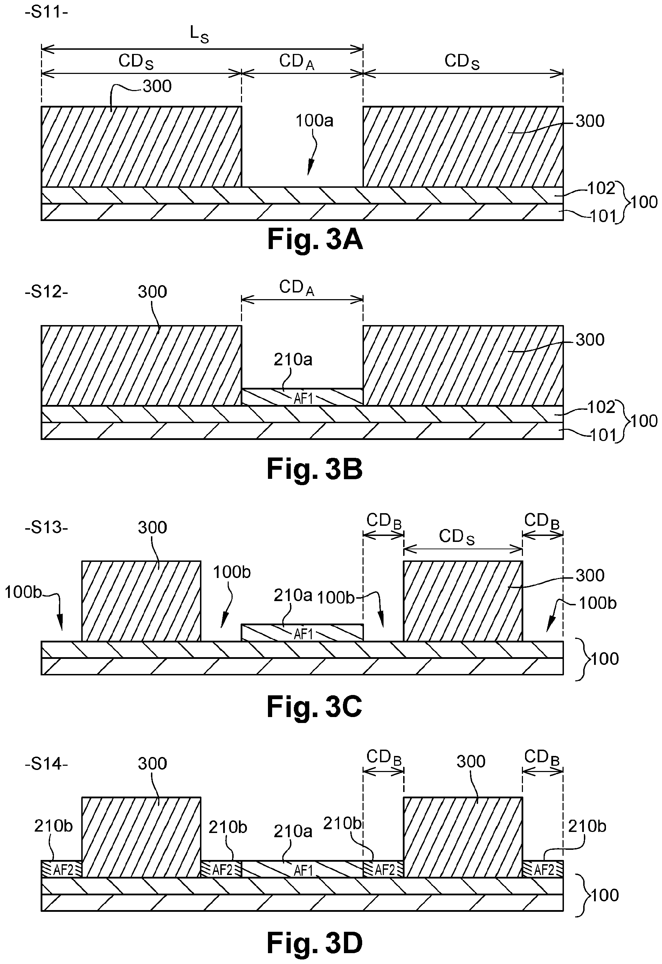

Le procédé décrit ci-après en relation avec les figures 3A-3F, 5A-5H et 6E-6J permet de former une structure de guidage chimique sur une face d'un substrat 100. Une structure de guidage chimique désigne ici un ensemble d'au moins deux motifs de polymère disposés sur des régions distinctes du substrat 100 et présentant des affinités chimiques différentes, cet ensemble étant répété périodiquement à la surface du substrat. Un contraste chimique est ainsi créé à la surface du substrat 100. La surface du substrat 100 peut présenter une affinité chimique identique à l'un des motifs de polymère.

Cette structure de guidage (ou de contraste) chimique est destinée à être recouverte de nano-objets organiques à assembler, dans le cadre d'un procédé d'auto-assemblage dirigé par chémo-épitaxie. Les nano-objets organiques peuvent être les domaines d'un copolymère à blocs, des protéines, des brins d'ADN ou des origamis d'ADN.

Le procédé de formation de structure guidage chimique est décrit ci-dessous en prenant comme exemple d'application l'auto-assemblage d'un copolymère à blocs, par exemple le PS-*b*-PMMA. Le contraste chimique permet de diriger (ou « guider ») l'organisation des blocs de monomère qui composent le copolymère. Ainsi, les affinités chimiques des motifs de polymère s'entendent par rapport aux blocs du copolymère. Ces affinités peuvent être choisies parmi les possibilités suivantes :
- affinité préférentielle pour l'un quelconque des blocs du copolymère ; ou
- neutre, c'est-à-dire avec une affinité équivalente pour chacun des blocs du copolymère.

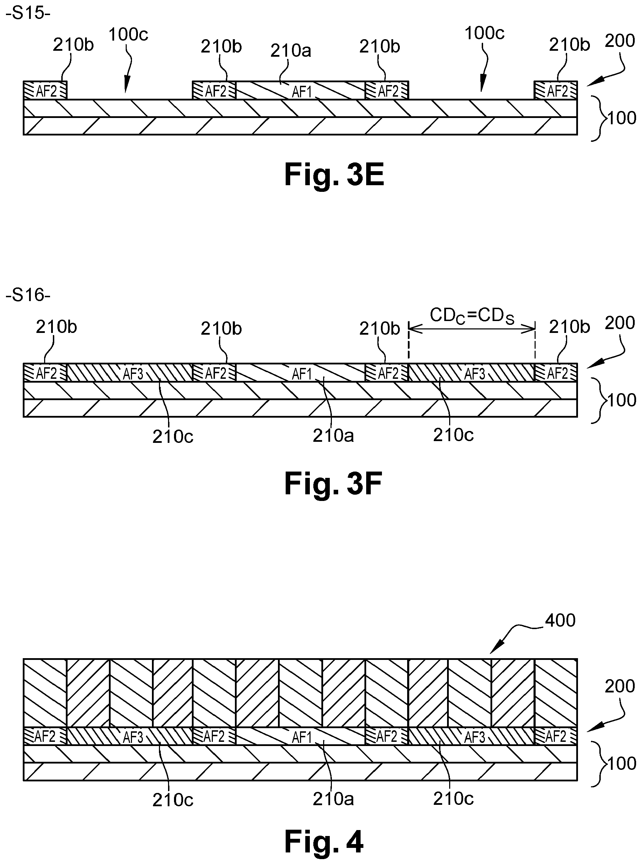

En référence aux figures 3E-3F, 5G-5H, 6I-6J, la structure de guidage chimique 200 comporte un ou plusieurs premiers motifs de guidage 210a, des deuxièmes motifs de guidage 210b et, selon les modes de mise en œuvre du procédé, des troisièmes motifs de guidage 210c, des quatrièmes motifs de guidage 210d et des cinquièmes motifs de motifs de guidage 210e. Les motifs de guidage 210a-210e sont distincts et disposés sur le substrat 100, dont la surface est avantageusement plane. Ils sont de préférence juxtaposés et peuvent occuper toute la surface du substrat 100 (cf. Figs.3F, 5H & 6J).

Les motifs de guidage 210a-210e ont pour rôle de fonctionnaliser chimiquement (et différemment) le substrat 100. Ils pourront donc également être qualifiés de motifs de fonctionnalisation. D'une façon commune à tous les modes de mise en œuvre, chaque premier motif de guidage 210a est constitué d'un premier matériau polymère ayant une affinité chimique AF1 (ici par rapport au copolymère à blocs). Les deuxièmes motifs de guidage 210b sont formés d'un deuxième matériau polymère ayant une affinité chimique AF2 différente de l'affinité chimique AF1 du premier matériau polymère.

Une faible différence d'épaisseur, typiquement inférieur à 10 nm, peux exister entre les différents motifs de guidage 210a-210e de la structure de guidage chimique 200 ou entre le substrat 100 et les motifs de guidage 210a-210e. Cette différence d'épaisseur, formant un contraste topographique, n'a toutefois pas d'impact négatif sur l'assemblage du copolymère à blocs.

Le substrat 100 peut comporter une couche de support 101, par exemple en silicium, et une couche superficielle 102 disposée sur la couche de support 101. La couche superficielle 102 est de préférence une couche destinée à former un masque dur, ce masque dur étant utilisé ultérieurement pour graver la couche de support 101 (dans le cadre du procédé d'auto-assemblage dirigé du copolymère à blocs). La couche superficielle 102 est par exemple constituée de nitrure de titane (TiN) ou d'oxyde d'hafnium (HfO₂).

Dans la description qui suit, on entend par « greffage » d'un polymère sur un substrat la formation de liaisons covalentes entre le substrat et les chaînes du polymère. À titre de comparaison, la réticulation d'un polymère implique la formation de plusieurs liaisons entre les chaînes du polymère sans forcément la formation de liaisons covalentes avec le substrat.

La dimension critique d'un motif désigne ci-après la plus petite dimension de ce motif dans un plan parallèle au substrat 100.

Les figures 3A à 3F sont des vues de coupe illustrant des étapes S11 à S16 du procédé de formation de structure de guidage chimique, selon un premier mode de mise en œuvre de l'invention.

La première étape S11 du procédé, illustrée par la figure 3A, consiste à former sur le substrat 100 des motifs sacrificiels 300, aussi appelés « mandrins » ou « motifs primaires ». Les motifs sacrificiels 300 sont séparés deux à deux par une zone (ou un espace) libre 100a de la surface du substrat 100. Ils ont de préférence la forme de lignes qui sont parallèles entre elles.

Les motifs sacrificiels 300 sont par exemple formés par dépôt d'une couche en matériau sacrificiel et structuration de la couche de matériau sacrificiel par photolithographie. L'épaisseur de la couche de matériau sacrificiel peut être comprise entre 100 nm et 200 nm. Le matériau sacrificiel est de préférence choisi parmi les matériaux qui peuvent être aisément gravés et retirés par gravure humide, de façon sélective par rapport au substrat 100 et aux matériaux polymères de fonctionnalisation. À titre d'exemple, on peut citer l'hydrogène silsesquioxane (HSQ), le nitrure de silicium (Si₃N₄), le titane (Ti), et les oxydes de silicium, tels que l'orthosilicate de tétraéthyle (TEOS) et le dioxyde de silicium (SiO₂).

Dans le plan de coupe de la figure 3A, les motifs sacrificiels 300 présentent avantageusement un pas de répétition L_{S} sensiblement égal à un multiple entier de la période naturelle L₀ du copolymère à blocs (L_{S} = n^{∗}L₀ ± 10 %, avec *n* un entier naturel non nul), par exemple égal à 4^{∗}L₀ ou 6^{∗}L₀ (soit 120 nm ou 180 nm dans le cas d'un copolymère à blocs ayant une période naturelle L₀ de 30 nm, comme le PS-*b*-PMMA). Pour ne pas alourdir inutilement la figure 3A et les figures suivantes, seuls deux motifs sacrificiels 300 ont été représentés. Le procédé de formation de structure de guidage chimique peut cependant être accompli avec un plus grand nombre de motifs sacrificiels 300.

La distance CD_{A} qui sépare deux motifs sacrificiels 300 consécutifs est de préférence sensiblement égale à un nombre impair de demi-périodes naturelles L₀/2 (CD_{A} = n1^{∗}L₀/2 ± 10 %, avec *n1* un entier naturel impair), par exemple égale à 3^{∗}L₀/2 ou 5^{∗}L₀/2 (soit 45 nm ou 75 nm dans le cas du PS-*b*-PMMA). Enfin, les motifs sacrificiels 300 ont de préférence une dimension critique CD_{S} sensiblement égale à un nombre impair de demi-périodes naturelles L₀/2 (CD_{S} = n2^{∗}L₀/2 ± 10%, avec *n2 = 2*^{∗}*n* - *n1* un entier naturel impair), par exemple égale à 5^{∗}L₀/2 ou 7^{∗}L₀/2 (soit 75 nm ou 105 nm dans le cas du PS-*b*-PMMA). La dimension critique CD_{S} des motifs sacrificiels 300 correspond ici à la largeur des lignes, mesurée parallèlement à la surface du substrat 100 dans le plan de coupe de la figure 3A.

En référence à la figure 3B, le procédé comprend ensuite une étape S12 de formation d'un ou plusieurs (en fonction du nombre de motifs sacrificiels 300) premiers motifs de guidage 210a sur le substrat 100, entre les motifs sacrificiels 300. De préférence, chaque premier motif de guidage 210a recouvre entièrement la zone libre 100a du substrat 100 située entre deux motifs sacrificiels 300 consécutifs. Chaque premier motif de guidage 210a présente donc une dimension critique (ou largeur) égale à la distance CD_{A} séparant deux motifs sacrificiels 300 consécutifs (soit la largeur de la zone libre 100a).

La formation du (ou des) premier(s) motif(s) de guidage 210a comprend de préférence le greffage du premier matériau polymère sur le substrat 100 (et plus particulièrement, sur la couche superficielle 102 lorsque celle-ci est présente). Pour ce faire, le premier polymère peut être dissous dans un solvant pour former une première solution de polymère, puis la première solution est déposée sur le substrat 100 de façon à recouvrir entièrement l'espace (c.-à-d. la zone du substrat) situé entre les motifs sacrificiels 300. La première solution de polymère forme alors un film dont l'épaisseur peut être comprise entre 15 nm et 50 nm. Le dépôt de la première solution sur le substrat 100 est de préférence accompli par centrifugation (ou « spin-coating » en anglais). Il est suivi d'une opération de greffage du premier polymère, par exemple par recuit. Le recuit est par exemple effectué à une température égale à 200°C, pendant une durée égale à 75 secondes, sur une plaque chauffante ou dans un four. Une partie du premier polymère en solution se fixe alors au substrat 100 et, de façon superflue, sur les parois latérales des motifs sacrificiels 300. Une opération de rinçage à l'aide d'un solvant permet ensuite d'éliminer la partie restante du premier polymère, qui n'a pas été greffée. Ce solvant est par exemple l'acétate de l'éther monométhylique du propylène glycol (PGMEA).

Les motifs sacrificiels 300 forment ainsi un masque ou pochoir pour localiser le greffage du premier polymère sur le substrat 100. L'épaisseur du premier motif de guidage 210a peut être comprise entre 3 nm et 7 nm (par exemple 4 nm dans les conditions de greffage susmentionnées).

De préférence, l'affinité chimique AF1 du premier polymère est neutre. Le premier polymère peut notamment être un copolymère statistique tel que le PS-*r-*PMMA.

A l'étape S13 de la figure 3C, les motifs sacrificiels 300 sont gravés partiellement et sélectivement par rapport au substrat 100 et au premier motif de guidage 210a, de façon à réduire la dimension critique CD_{S} des motifs sacrificiels 300. Pour ce faire, un procédé de gravure humide est employé. Ce procédé de gravure consiste à exposer les motifs sacrificiels 300 à une solution chimique, par exemple une solution d'acide fluorhydrique (HF). La gravure par voie humide ayant un caractère isotrope, les dimensions des motifs sacrificiels 300 sont réduites de façon uniforme.

La gravure partielle des motifs sacrificiels 300 libère deux zones 100b de la surface du substrat 100, disposées de part et d'autre de chaque motif sacrificiel 300 dans le plan de coupe de la figure 3C. Les conditions de la gravure (temps d'exposition à la solution chimique, concentration de la solution chimique...) sont de préférence fixées de sorte que chaque zone libre 100b du substrat 100 présente une largeur CD_{B} d'environ une demi-période naturelle L₀/2 du copolymère à blocs (CD_{B} = L₀/2 ± 10 %, soit 15 nm dans le cas du PS-*b*-PMMA). Autrement dit, la dimension critique CD_{S} des motifs sacrificiels 300 est réduite de deux demi-périodes naturelles L₀/2.

Ainsi, l'étape S13 de la figure 3C est une étape de rétrécissement par gravure (ou « trim etch » en anglais) des motifs sacrificiels 300, accomplie par voie humide, et non par voie sèche (gravure plasma) comme dans les procédés de l'art antérieur. Comparée à la gravure sèche, la gravure humide permet de contrôler plus facilement la diminution de la dimension critique CD_{S} des motifs sacrificiels 300, car la vitesse de gravure peut être contrôlée très précisément en jouant sur la dilution de la solution de HF. Elle est en outre plus simple à mettre en œuvre. Par ailleurs, la gravure humide ne modifie pas les propriétés de surface du substrat.

A titre d'exemple, le substrat 100 est plongé pendant 1 min dans un bain d'acide fluorhydrique (HF) de concentration égale à 1 % pour diminuer de 30 nm la dimension critique de motifs sacrificiels 300 en TEOS.

L'étape S14 de la figure 3D consiste à former les deuxièmes motifs de guidage 210b, dans les zones libres 100b du substrat 100 créées par la gravure partielle des motifs sacrificiels 300. De préférence, chaque zone libre 100b du substrat 100 est entièrement recouverte par un deuxième motif de guidage 210b. Les deuxièmes motifs de guidage 210b présentent alors une dimension critique égale à la largeur CD_{B} des zones libres 100b.

Les deuxièmes motifs de guidage 210b sont avantageusement formés de la façon décrite en relation avec la figure 3B, c.-à-d. par dépôt sur le substrat 100 d'une deuxième solution de polymère dans laquelle est dissous le deuxième matériau polymère, greffage puis rinçage. Le deuxième polymère se greffe ainsi sur le substrat 100 en dehors des motifs sacrificiels 300 et du premier motif de guidage 210a. Bien que la deuxième solution de polymère recouvre le premier motif de guidage 210a, le deuxième matériau polymère ne remplace pas ou ne se mélange pas au premier matériau polymère lors de l'opération de greffage. L'épaisseur des deuxièmes motifs de guidage 210b (après recuit et rinçage) peut être comprise entre 3 nm et 10 nm (par exemple 4 nm).

Les masses molaires des premier et deuxième polymères sont avantageusement inférieures à 5 kg.mol⁻¹, afin d'assurer une forte densité de greffage au niveau du substrat 100. Les motifs de polymère sont ainsi minces et compacts.

De préférence, l'affinité chimique AF2 du deuxième polymère (deuxièmes motifs de guidage 210b) est préférentielle pour l'un quelconque des blocs du copolymère, par exemple le bloc PS du copolymère PS-*b*-PMMA. Le deuxième polymère peut notamment être un homopolymère, par exemple de polystyrène (h-PS).

Enfin, à l'étape S15 de la figure 3E, les motifs sacrificiels 300 sont retirés sélectivement par rapport au substrat 100 et aux motifs de guidage 210a-210b, de préférence par gravure humide en utilisant la même solution de gravure qu'à l'étape de rétrécissement S13 des motifs sacrificiels 300 (Fig.3C). Par exemple, des motifs sacrificiels 300 de dimension critique CD_{S} égale à 45 nm sont gravés totalement en plongeant le substrat 100 dans un bain d'acide fluorhydrique (HF) de concentration égale à 1 % pendant 5 min.

Seuls subsistent alors sur le substrat 100, à l'issue de l'étape de retrait S15, le premier motif de guidage 210a et les deuxièmes motifs de guidage 210b. La surface du substrat 100 comprend des zones libres 100c (c.-à-d. découvertes) créées par le retrait des motifs sacrificiels 300.

L'étape S15 de retrait des motifs sacrificiels 300 est avantageusement suivie d'un rinçage au solvant (eau, PGMEA...), afin d'éliminer les résidus de gravure.

En référence à la figure 3F, le procédé peut comprendre une étape supplémentaire S16 de formation de troisièmes motifs de guidage 210c sur le substrat 100, en compléments des premiers et deuxièmes motifs de guidage 210a-210b. Les troisièmes motifs de guidage 210c sont formés dans les zones libres 100c du substrat 100 créées par le retrait des motifs sacrificiels 300. Ils sont constitués d'un troisième matériau polymère ayant une affinité chimique AF3 différente de l'affinité chimique AF2 du deuxième matériau polymère (deuxièmes motifs de guidage 210b). L'affinité chimique AF3 du troisième polymère peut être neutre. Elle est de préférence identique à l'affinité chimique AF1 du premier polymère (premier motif de guidage 210a).

De façon avantageuse, le troisième polymère est identique au premier polymère. Seuls deux polymères différents sont alors employés dans le procédé des figures 3A-3F, ce qui le rend particulièrement simple à mettre en œuvre.

L'étape S16 de formation des troisièmes motifs de guidage 210c peut être accomplie de la même façon que l'étape S12 de formation du premier motif de guidage 210a (ou l'étape S14 de formation des deuxièmes motifs de guidage 210b) et comprendre le greffage du troisième polymère sur le substrat 100 en dehors des motifs de guidage 210a-210b. Les troisièmes motifs de guidage 210c présentent avantageusement une dimension critique CD_{C} égale à la dimension critique CD_{S} des motifs sacrificiels 300 après l'étape de rétrécissement S13, soit un nombre impair de demi-périodes naturelles L₀/2 (CD_{C} = (n2-2)^{∗}L₀/2 ± 10 %), par exemple 3^{∗}L₀/2 ou 5^{∗}L₀/2.

La structure de guidage 200 obtenue à l'issue de la figure 3F peut être utilisée dans un procédé d'auto-assemblage dirigé de copolymère à blocs (« Directed Self-Assembly », DSA), et plus particulièrement dans un procédé de chémo-épitaxie, afin de générer des motifs de très hautes résolution et densité.

En référence à la figure 4, le procédé de chémo-épitaxie comporte (outre la formation de la structure de guidage 200) une étape de dépôt d'un copolymère à blocs 400 de morphologie lamellaire sur la structure de guidage chimique 200 et une étape d'assemblage du copolymère à blocs 400, par exemple par recuit thermique. Le copolymère à blocs 400 peut être un copolymère di-blocs (deux monomères) ou multi-blocs (plus de deux monomères), un mélange de polymères, un mélange de copolymères ou encore le mélange d'un copolymère et d'un homopolymère. Les domaines du copolymère sont après assemblage orientés perpendiculairement au substrat 100, grâce au premier motif de guidage 210a et aux troisièmes motifs de guidage 210c (dont l'affinité est neutre).

Le copolymère à blocs 400 peut être un copolymère à blocs standard (L₀ ≥ 25 nm) ou un copolymère à blocs « high-X » (L₀ < 25 nm). Il peut notamment être choisi parmi les suivants :
- PS-*b*-PMMA : polystyrène-bloc-polyméthylméthacrylate ;
- PS-*b*-PMMA, dont au moins un des deux blocs est modifié chimiquement pour diminuer la période naturelle du copolymère ;
- PS-*b*-PDMS : polystyrène-bloc-polydiméthylsiloxane ;
- PS-*b*-PLA : polystyrène-bloc-acide polylactique ;
- PS-*b*-PEO : polystyrène-bloc-polyoxyde d'éthylène ;
- PS-*b*-PMMA-*b*-PEO : polystyrène-bloc-polyméthylméthacrylate-bloc-polyoxyde d'éthylène ;
- PS-*b*-P2VP : polystyrène-bloc-poly(2vinylpyridine) ;
- PS-*b*-P4VP : polystyrène-bloc-poly(4vinylpyridine) ;
- PS-*b*-PFS : poly(styrene)-block-poly(ferrocenyldimethylsilane) ;
- PS-*b*-PI-*b*-PFS : poly(styrene)-block-poly(isoprene)-block-poly(ferrocenyldimethylsilane) ;
- PS-*b*-P(DMS-*r*-VMS) : polystyrene-block-poly(dimethylsiloxane-r-vinylmethylsiloxane) ;
- PS-*b*-PMAPOSS : polystyrene-block-poly(methyl acrylate)POSS ;
- PDMSB-*b*-PS : poly(1,1-dimethylsilacyclobutane)-block-polystyrene ;
- PDMSB-*b*-PMMA : poly(1,1-dimethylsilacyclobutane)-block-poly(methyl methacrylate) ;
- PMMA-*b*-PMAPOSS : poly(methyl methacrylate)-block-poly(methyl acrylate)POSS ;
- P2VP-*b*-PDMS : poly(2-vinylpyridine)-block-poly(dimethyl siloxane) ;
- PTMSS-*b*-PLA : poly(trimethylsilylstyrene)-block-poly(D,L-lactide) ;
- PTMSS-*b*-PDLA : poly(trimethylsilylstyrene)-block-poly(D-lactic acid) ;
- PTMSS-*b*-PMOST : poly(trimethylsilylstyrene)-block-poly(4-methoxystyrene) ;
- PLA-*b*-PDMS : poly(D,L-lactide)-block-poly(dimethylsiloxane) ;
- PAcOSt-*b*-PSi2St : poly(4-acetoxystyrene)-block-poly(4-(Bis(trimethylsilyl)methyl)styrene) ;
- 1,2-PB-*b*-PDMS : 1,2-polybutadiene-block-poly(dimethyl siloxane) ;
- PtBS-*b*-PMMA : poly(4-tert-butylstyrene)-block-poly(methyl methacrylate) ;
- PCHE-*b*-PMMA : polycyclohexane-block-poly(methyl methacrylate) ;
- MH-*b*-PS : maltoheptaose-block-polystyrene.

La structure de guidage chimique 200 de la figure 3E peut être également utilisée pour l'assemblage du copolymère à blocs 400. Autrement dit, l'étape S16 de formation des troisièmes motifs de guidage 210c est facultative. Pour augmenter la cinétique d'assemble et/ou réduire le nombre de défauts d'organisation, il est toutefois préférable que le substrat 100 présente (en surface) une affinité chimique neutre.

La formation des troisièmes motifs de guidage 210c est avantageuse lorsque le substrat ne présente pas l'affinité chimique souhaitée et/ou lorsqu'on cherche à obtenir une structure de guidage la plus plane possible.

Une couche superficielle en nitrure de titane (TiN) est hydrophile et présente par conséquent une affinité chimique préférentielle pour le bloc PMMA. Le procédé des figures 3A-3F peut donc être adapté pour que les zones libres 100c du substrat 100 présentent une largeur égale à la moitié de la période naturelle du copolymère à blocs (CD_{C} = 0,5^{∗}L₀), soit la dimension critique des domaines du bloc PMMA. Le premier motif de guidage 210a et les deuxièmes motifs de guidage 210b peuvent alors présenter la même affinité chimique neutre mais être formés de matériaux polymères différents. Dans le cas d'un substrat présentant une affinité préférentielle pour l'un quelconque des blocs du copolymère (par exemple le bloc PMMA), le procédé peut alternativement comporter qu'une seule étape de dépôt d'un matériau polymère présentant une affinité chimique AF1 neutre, après l'étape de gravure humide des motifs sacrificiels et avant l'étape de retrait des motifs sacrificiels (de dimension critique CD_{S} = 0,5^{∗}L₀).

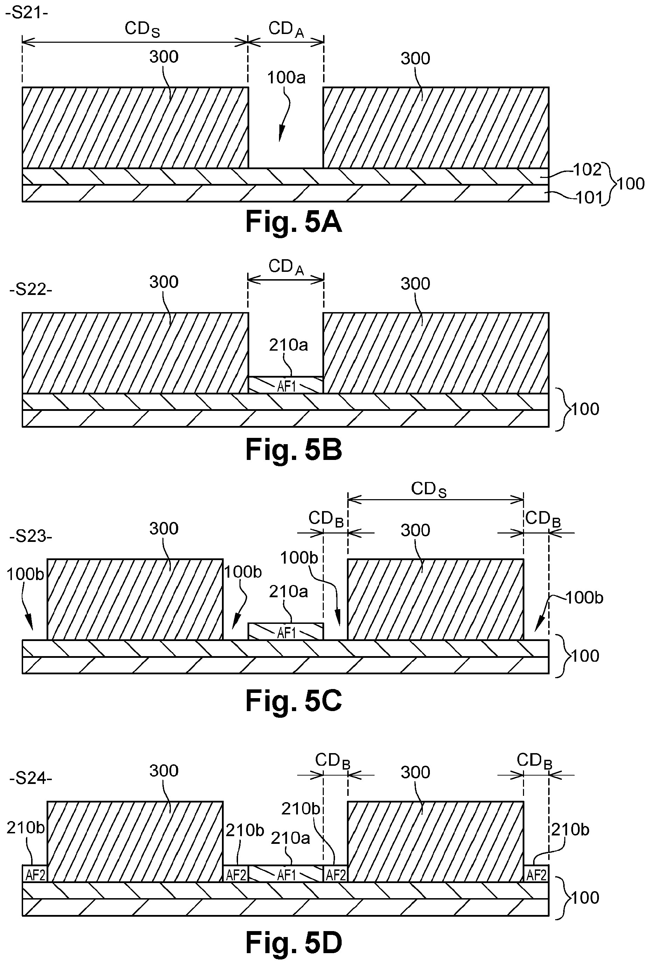

Les figures 5A à 5H représentent des étapes S21 à S28 du procédé de formation de structure de guidage chimique, d'après un deuxième mode de mise en œuvre de l'invention.

Les étapes S21-S24 des figures 5A-5D sont identiques aux étapes S11-S14 décrites en relation avec les figures 3A-3D et aboutissent à une structure (illustrée par la figure 5D) très proche de celle de la figure 3D. La seule différence entre les figures 3A-3D et les figures 5A-5D est la valeur de la dimension critique CD_{S} des motifs sacrificiels 300. La dimension critique CD_{S} des motifs sacrificiels 300 sur les figures 5A-5D est supérieure à celle des motifs sacrificiels 300 sur les figures 3A-3D. Elle est par exemple égale à 9^{∗}L₀/2 (soit CD_{S} = 135 nm dans le cas du PS-*b*-PMMA) avant l'étape de rétrécissement par gravure S23 et à 7^{∗}L₀/2 (soit CD_{S} = 105 nm dans le cas du PS-*b*-PMMA) après l'étape de rétrécissement par gravure S23. Comme précédemment, la distance CD_{A} qui séparent initialement deux motifs sacrificiels 300 consécutifs peut être égale à 3^{∗}L₀/2 (45 nm) et le pas de répétition Ls des motifs sacrificiels 300 peut être égal à 6^{∗}L₀ (180 nm).

Ainsi, la dimension critique CD_{S}, l'espacement CD_{A} et le pas de répétition Ls des motifs sacrificiels 300 sont définis de la même façon que précédemment, en fonction d'un nombre entier naturel (impair) de demi-périodes naturelles L₀/2 ou d'un nombre entier naturel (non nul) de périodes naturelles L₀. Les deuxièmes motifs de guidage 210b ont également dans ce deuxième mode de mise en œuvre une dimension critique CD_{B} d'environ une demi-période naturelle L₀/2.

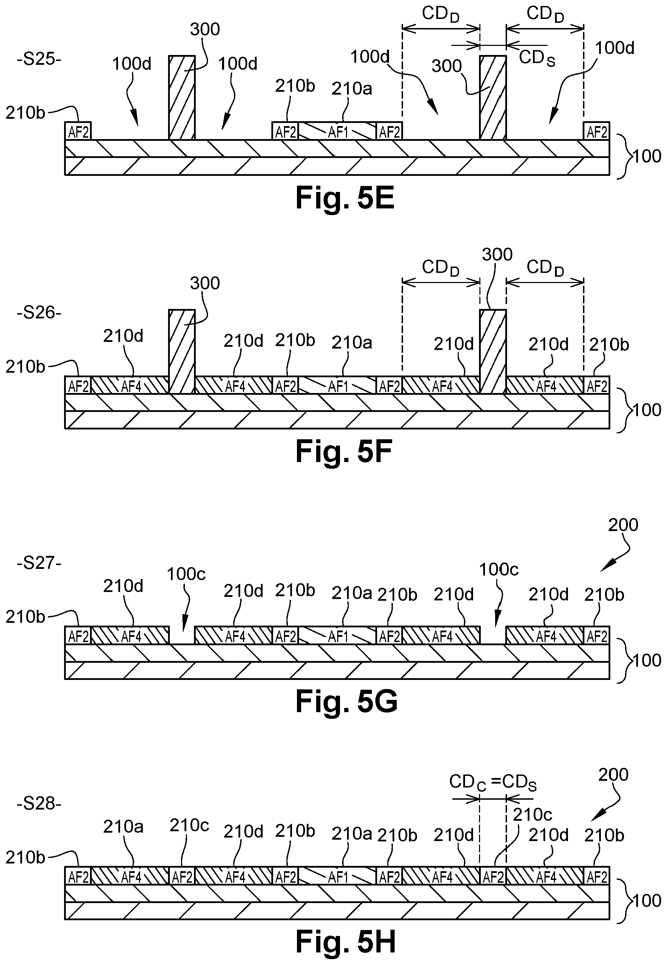

L'étape S25 de la figure 5E est une deuxième étape de rétrécissement des motifs sacrificiels 300, par gravure humide et sélective par rapport au substrat 100 et aux motifs de guidage 210a-210b. De préférence, les motifs sacrificiels 300 sont gravés partiellement en employant la même solution chimique qu'à la première étape de rétrécissement S23. La dimension critique CD_{S} des motifs sacrificiels 300 est avantageusement réduite jusqu'à atteindre une valeur d'environ une demi-période naturelle L₀/2.

Cette deuxième gravure partielle des motifs sacrificiels 300 génèrent de nouvelles zones libres 100d à la surface du substrat 100. Ces zones libres 100d, disposées de part et d'autre des motifs sacrificiels 300, ont une largeur CD_{D} égale à un nombre impair de demi-périodes naturelles L₀/2 (CD_{D} = n3^{∗}L₀/2 ± 10 %, avec *n3* = *(n2-2-1)*/*2* un entier naturel impair).

En référence à la figure 5F, le procédé comprend ensuite une étape de formation de quatrièmes motifs de guidage 210d dans les zones libres 100d du substrat 100. Les quatrièmes motifs de guidage 210d sont formés d'un quatrième matériau polymère présentant une affinité chimique AF4 différente de l'affinité chimique AF2 du deuxième matériau polymère (deuxièmes motifs de guidage 210b). L'affinité chimique AF4 du quatrième polymère peut être neutre. Elle est de préférence identique à l'affinité chimique AF1 du premier polymère (premier motif de guidage 210a). De façon avantageuse, le quatrième polymère est identique au premier polymère.

L'étape S26 de formation des quatrièmes motifs de guidage 210d peut être accomplie de la même façon que l'étape S22 de formation du premier motif de guidage 210a et comprendre le greffage du quatrième polymère sur le substrat 100 en dehors des motifs sacrificiels 300 et des motifs de guidage 210a-210b. Les quatrièmes motifs de guidage 210d présentent avantageusement une dimension critique égale à largeur CD_{D} des zones libres 100d. La dimension critique CD_{D} des quatrièmes motifs de guidage 210d est de préférence égale à la dimension critique CD_{A} du premier motif de guidage 210a (d'où n3 = n1), soit ici 3^{∗}L₀/2 (45 nm).

A l'étape S27 de la figure 5G, les motifs sacrificiels 300 sont retirés, de préférence de la façon décrite en relation avec la figure 3E (c.-à-d. par gravure humide), générant ainsi les zones libres 100c.

Enfin, en S28 (cf. Fig.5H), les troisièmes motifs de guidage 210c sont avantageusement formés sur le substrat 100 dans les zones libres 100c créées par le retrait des motifs sacrificiels 300, comme cela a été décrit en relation avec la figure 3F.

Ainsi, dans ce deuxième mode de mise en œuvre, les troisièmes motifs de guidage 210c ont une dimension critique CD_{C} égale à la dimension critique CD_{S} des motifs sacrificiels 300 après la deuxième étape de rétrécissement S25, soit ici une demi-période naturelle L₀/2. En outre, le troisième polymère formant les troisièmes motifs de guidage 210c présente la même affinité chimique (AF2) que le deuxième polymère (deuxièmes motifs de guidage 210b), c.-à-d. une affinité préférentiellement pour l'un des blocs du copolymère. De façon avantageuse, le troisième polymère est identique au deuxième polymère.

De façon analogue aux figures 3E-3F, chacune des structures de guidage chimique 200 représentées sur les figures 5G-5H peut être utilisée pour l'assemblage du copolymère à blocs 400.

Pour un même pas de répétition des motifs sacrificiels 300 (par ex. L_{S}= 6^{∗}L₀), la structure de guidage 200 de la figure 5H (ou de la figure 5G) comprend un nombre plus important de motifs de guidage que celle représentée par la figure 3F (ou la figure 3E). Elle permet par conséquent un assemblage du copolymère à blocs plus rapide et/ou moins sensible aux défauts d'organisation.

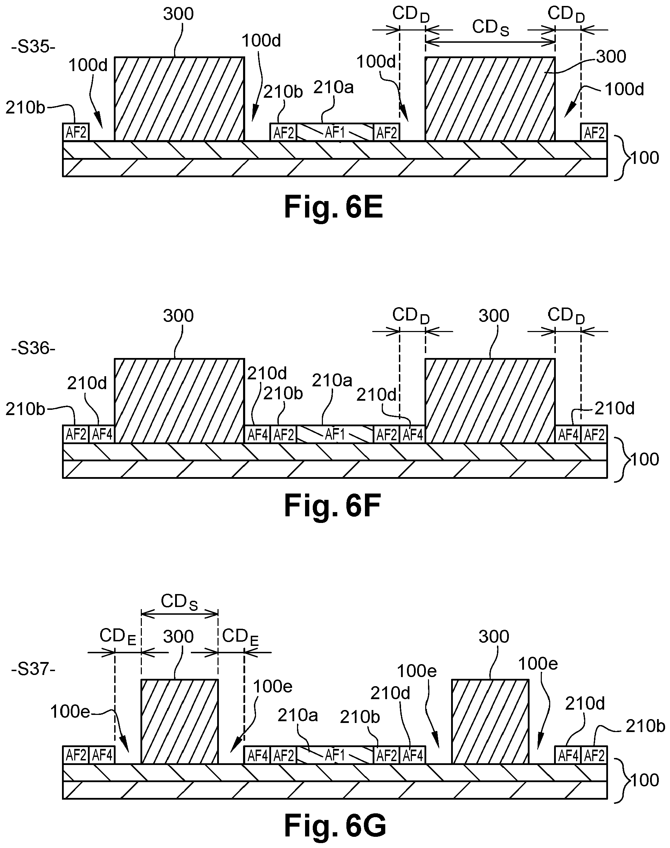

Les figures 6E à 6J représentent des étapes S35 à S40 du procédé de formation de structure de guidage chimique, d'après un troisième mode de mise en œuvre de l'invention. Ces étapes S35-S40 sont accomplies à la suite des étapes S21-S24 représentées par les figures 5A-5D et viennent par conséquent en remplacement des étapes S25-S28 des figures 5E-5H.

L'étape S35 de la figure 6E est une deuxième étape de rétrécissement des motifs sacrificiels 300, après la première étape de rétrécissement S23 de la figure 5C. Cette deuxième étape de rétrécissement S35 est accomplie par gravure humide, de préférence en employant la même solution chimique qu'à la première étape de rétrécissement S23. Elle est en outre identique à la deuxième étape de rétrécissement S25 du procédé selon le deuxième mode de mise en œuvre de l'invention (Fig.5E), à la différence que la dimension critique CD_{S} des motifs sacrificiels 300 est ici réduite de seulement deux demi-périodes naturelles Lₒ/2.

A l'étape S36 de la figure 6F, les quatrièmes motifs de guidage 210d sont formés sur le substrat 100 (dans les zones libres 100d) de la même façon qu'à l'étape S26 de la figure 5F. Cependant, dans ce troisième mode de mise en œuvre du procédé, ils ont une dimension critique CD_{D} d'environ une demi-période naturelle (CD_{D} = L₀/2 ± 10 %).

L'affinité chimique AF4 du quatrième polymère (quatrièmes motifs de guidage 210d) est différente de l'affinité chimique AF2 du deuxième polymère (deuxièmes motifs de guidage 210b). Elle est avantageusement préférentielle pour un premier bloc « A » du copolymère (par ex. le bloc PS), tandis que l'affinité chimique AF2 du deuxième polymère est préférentielle pour un deuxième bloc « B » du copolymère (par ex. le bloc PMMA).

L'étape S37 de la figure 6G est une troisième étape de rétrécissement des motifs sacrificiels 300 par gravure humide. Les motifs sacrificiels 300 sont gravés sélectivement par rapport au substrat 100 et aux motifs de guidage 210a, 210b et 210d, de préférence en employant la même solution chimique qu'aux première et deuxième étapes de rétrécissement S23 et S35. A nouveau, la dimension critique CD_{S} des motifs sacrificiels 300 est de préférence réduite de deux demi-périodes naturelles L₀/2. Le rétrécissement des motifs sacrificiels 300 génère à la surface du substrat 100 deux nouvelles zones libres 100e, disposées de part et d'autre de chaque motif sacrificiel 300. Les zones libres 100e ont ici une largeur CD_{E} égale à une demi-période naturelle environ (CD_{E} = L₀/2 ± 10 %).

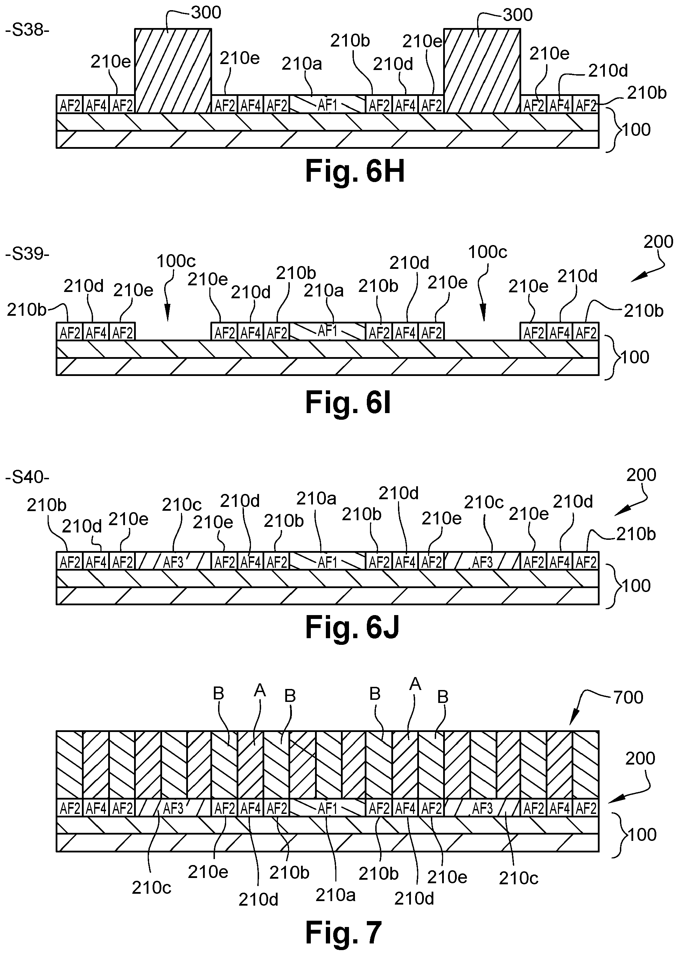

L'étape S38 de la figure 6H consiste à former des cinquièmes motifs de guidage 210e sur le substrat 100, dans les zones libres 100e obtenues à l'issue de la troisième étape S37 de rétrécissement des motifs sacrificiels 300.

Les cinquièmes motifs de guidage 210e sont formés d'un cinquième matériau polymère présentant l'affinité chimique AF2 du deuxième matériau polymère (deuxièmes motifs de guidage 210b), c.-à-d. une affinité préférentielle pour le bloc « B » du copolymère. De façon avantageuse, le cinquième polymère est identique au deuxième polymère.

L'étape S38 de formation des cinquièmes motifs de guidage 210e peut être accomplie de la même façon que l'étape S22 de formation du premier motif de guidage 210a et comprendre le greffage du cinquième polymère sur le substrat 100 en dehors des motifs sacrificiels 300 et des motifs de guidage 210a, 210b et 210d. Les cinquièmes motifs de guidage 210e présentent avantageusement une dimension critique égale à largeur CD_{E} des zones libres 100e et à la dimension critique CD_{D} des deuxièmes motifs de guidage 210b, soit une demi-période naturelle environ (CD_{E} = L₀/2 ± 10 %).

A l'étape S39 de la figure 6I, les motifs sacrificiels 300 sont ensuite retirés (de préférence par gravure humide).

Enfin, en S40 (cf. Fig.6J), les troisièmes motifs de guidage 210c sont avantageusement formés sur le substrat 100 dans les zones libres 100c créées par le retrait des motifs sacrificiels 300, par exemple en y greffant le troisième polymère.

Les troisièmes motifs de guidage 210c ont, dans ce troisième mode de mise en œuvre, une dimension critique CD_{C} égale à la dimension critique CD_{S} des motifs sacrificiels 300 après la troisième étape de rétrécissement S37, soit un nombre impair de demi-périodes naturelles L₀/2 (CD_{C} = (n2-2^{∗}3)^{∗}L₀/2 ± 10 %), par exemple 3^{∗}L₀/2. L'affinité chimique AF3 du troisième polymère peut être neutre. Elle est de préférence identique à l'affinité chimique AF1 du premier polymère (premier motif de guidage 210a). De façon avantageuse, le troisième polymère est identique au premier polymère (premier motif de guidage 210a).

Dans le premier mode de mise en œuvre (Figs.3A-3F) et le troisième mode de mise en œuvre (Figs.5A-5D et 6E-6J) du procédé, les motifs sacrificiels 300 sont avantageusement dimensionnés de sorte que la dimension critique CD_{S} des motifs sacrificiels 300 soit, après la dernière étape de rétrécissement (S13 ou S37), égale à la distance CD_{A} qui séparent initialement deux motifs sacrificiels 300 consécutifs. La dimension critique CD_{C} des troisièmes motifs de guidage 210c est alors égale à celle du premier motif de guidage 210a (CD_{C} = CD_{A}).

De façon analogue aux figures 3E-3F et aux figures 5G-5H, chacune des structures de guidage chimique 200 représentées sur les figures 6I-6J peut être utilisée pour l'assemblage du copolymère à blocs 400.

La structure de guidage chimique de la figure 6J peut être à tonalité triple, notamment lorsque les conditions suivantes sont réunies :
- le premier polymère (premier motif de guidage 210a) et/ou le troisième polymère (troisièmes motifs de guidage 210c) présentent une affinité chimique AF1/AF3 neutre ;
- le deuxième polymère (deuxièmes motifs de guidage 210b) et le cinquième polymère (cinquièmes motifs de guidage 210e) présentent une affinité chimique AF2 préférentielle pour le bloc « B » du copolymère ;
- le quatrième polymère (quatrièmes motifs de guidage 210d) présente une affinité chimique AF4 préférentielle pour le bloc « A » du copolymère.

La figure 7 représente schématiquement l'assemblage d'un copolymère à blocs 700 di-blocs (A-*b*-B) sur la structure de guidage chimique à tonalité triple de la figure 6J. Les quatrièmes motifs de guidage 210d sont recouverts par des domaines du bloc « A ». Les deuxièmes motifs de guidage 210b et cinquièmes motifs de guidage 210e sont recouverts par des domaines du bloc « B ». L'ensemble des domaines du bloc « A » et du bloc « B » sont orientés perpendiculairement au substrat 100 grâce au premier motif de guidage 210a et aux troisièmes motifs de guidage 210c dont l'affinité est neutre.

Une telle structure de guidage chimique à triple tonalité garantit une cinétique d'assemblage élevée et/ou un très faible nombre de défauts d'organisation.

Les masses molaires des troisième, quatrième et/ou cinquième polymères sont avantageusement inférieures à 5 kg.mol-1, afin d'assurer une forte densité de greffage au niveau du substrat 100. Les motifs de polymère sont ainsi minces et compacts.

Le procédé de formation de structure de guidage chimique décrit ci-dessus est particulièrement avantageux car il assure un contrôle précis de la dimension critique des motifs de guidage. Le rétrécissement des motifs sacrificiels 300 (par gravure humide) est facilité par le fait que les motifs sacrificiels ont initialement (c.-à-d. avant gravure) une dimension critique CD_{S} importante, typiquement supérieur à 5^{∗}L₀/2. Le procédé de formation procure en outre une totale liberté dans le choix des affinités chimiques, car les matériaux polymères déposés ne subissent aucun traitement susceptible de modifier leur affinité chimique. Enfin, le greffage de matériau polymère est une technique particulièrement simple à mettre en œuvre, qui permet l'obtention de motifs de polymère compacts et homogènes.

Le procédé de formation n'est pas limité aux modes de mise en œuvre décrits en référence aux figures 3, 5 et 6 de nombreuses variantes et modifications apparaîtront à l'homme du métier. En particulier, les motifs de guidage 210a-210e peuvent présenter d'autres valeurs de dimension critique et les matériaux polymères peuvent présenter d'autres affinités chimiques ou compositions que celles décrites précédemment. De même, d'autres copolymères à blocs pourraient être utilisés.

Enfin, bien qu'il ait été décrit en considérant l'auto-assemblage d'un copolymère à blocs, le procédé de formation de structure de guidage chimique peut être employé pour l'auto-assemblage par chémo-épitaxie de tout type de nano-objets. Les affinités chimiques AF1-AF4 des matériaux polymères sont définies par rapport aux nano-objets à assembler.

## Revendications

1. Procédé de formation d'une structure de guidage chimique (200) destinée à l'auto-assemblage de nano-objets organiques (400, 700) par chémo-épitaxie, le procédé comprenant les étapes suivantes :
- former (S11, S21) sur un substrat (100) des motifs sacrificiels (300) ayant une dimension critique (CD_{S}) dans un plan parallèle au substrat (100) ;
- former (S12, S22) sur le substrat (100), entre les motifs sacrificiels (300), au moins un premier motif (210a) en un premier matériau polymère, le premier matériau polymère ayant une première affinité chimique (AF1) par rapport aux nano-objets organiques ;
- graver (S13, S23) partiellement les motifs sacrificiels (300) de façon à réduire la dimension critique (CD_{S}) des motifs sacrificiels, les motifs sacrificiels (300) étant gravés sélectivement par rapport audit au moins un premier motif (210a) en utilisant un premier procédé de gravure humide ;
- former (S14, S24) sur le substrat (100), dans des zones (100b) créées par la gravure partielle des motifs sacrificiels (300), des deuxièmes motifs (210b) en un deuxième matériau polymère, le deuxième matériau polymère ayant une deuxième affinité chimique (AF2) par rapport aux nano-objets organiques, différente de la première affinité chimique (AF1); et
- retirer (S15, S27, S39) les motifs sacrificiels (300).

2. Procédé selon la revendication 1, comprenant en outre une étape (S16, S28, S40) de formation sur le substrat (100), dans des zones (100c) créées par le retrait des motifs sacrificiels (300), de troisièmes motifs (210c) en un troisième matériau polymère.

3. Procédé selon la revendication 2, dans lequel le troisième matériau polymère présente une troisième affinité chimique (AF3) par rapport aux nano-objets organiques, différente de la deuxième affinité chimique (AF2).

4. Procédé selon l'une des revendications 2 et 3, dans lequel le troisième matériau polymère présente la première affinité chimique (AF1).

5. Procédé selon l'une des revendications 1 et 2, comprenant en outre, entre l'étape (S24) de formation des deuxièmes motifs (210b) et l'étape (S27, S39) de retrait des motifs sacrificiels (300), les étapes suivantes :
- graver (S25, S35) partiellement les motifs sacrificiels (300) de façon à réduire la dimension critique (CD_{S}) des motifs sacrificiels, les motifs sacrificiels étant gravés sélectivement par rapport audit au moins un premier motif (210a) et aux deuxièmes motifs (210b) en utilisant un deuxième procédé de gravure humide ;
- former (S26, S36) sur le substrat (100), dans des zones (100d) créées par la gravure partielle des motifs sacrificiels (300), des quatrièmes motifs (210d) en un quatrième matériau polymère.

6. Procédé selon la revendication 5, dans lequel le quatrième matériau polymère présente une quatrième affinité chimique (AF4) par rapport aux nano-objets organiques, différente de la deuxième affinité chimique (AF2).

7. Procédé selon l'une des revendications 5 et 6, dans lequel le quatrième matériau polymère présente la première affinité chimique (AF1).

8. Procédé selon l'une des revendications 5 et 6, comprenant en outre, entre l'étape (S36) de formation des quatrièmes motifs (210d) et l'étape (S39) de retrait des motifs sacrificiels (300), les étapes suivantes :
- graver (S37) partiellement les motifs sacrificiels (300) de façon à réduire la dimension critique (CD_{S}) des motifs sacrificiels, les motifs sacrificiels étant gravés sélectivement par rapport audit au moins un premier motif (210a), aux deuxièmes motifs (210b) et aux quatrièmes motifs (210d) en utilisant un troisième procédé de gravure humide ;
- former (S38) sur le substrat, dans des zones (100e) créées par la gravure partielle des motifs sacrificiels (300), des cinquièmes motifs (210e) en un cinquième matériau polymère.

9. Procédé selon la revendication 8, dans lequel le quatrième matériau polymère présente une quatrième affinité chimique (AF4) par rapport aux nano-objets organiques, différente de la deuxième affinité chimique (AF2), et le cinquième matériau polymère présente la deuxième affinité chimique (AF2).

10. Procédé selon l'une des revendications 8 et 9, dans lequel le premier procédé de gravure humide, le deuxième procédé de gravure humide et le troisième procédé de gravure humide sont accomplis au moyen d'une même solution chimique.

11. Procédé selon l'une quelconque des revendications 1 à 10, dans lequel les motifs sacrificiels (300) sont constitué d'un oxyde de silicium.

12. Procédé de chémo-épitaxie comprenant les étapes suivantes :
- former une structure de guidage chimique (200) sur un substrat (100) à l'aide d'un procédé selon l'une quelconque des revendications 1 à 11 ;
- déposer des nano-objets organiques (400, 700) sur la structure de guidage chimique (200) ; et
- assembler les nano-objets organiques (400, 700).

13. Procédé selon l'une quelconque des revendications 1 à 12, dans lequel les nano-objets organiques sont choisis parmi des domaines d'un copolymère à blocs, des brins d'ADN, des origamis d'ADN et des protéines.
